# EUROPEAN PATENT APPLICATION

(11) **EP 1 696 488 A1**
(43) Date of publication of application: **30.08.2006**
(21) Application number: 05027682.3
(22) Date of filing: 16.12.2005
(51) Int. Cl.: H01L 27/00

(54) **Organic electroluminescence type display apparatus**

(30) Priority: 25.02.2005 JP 2005051262
(71) Applicant: MITSUBISHI DENKI KABUSHIKI KAISHA, Chiyoda-ku Tokyo 100-8310 (JP)
(72) Inventor: Nagayama, Kensuke, c/o Melco Display Tech Inc, Kukichi-gun Kumamoto 861-1198 (JP); Ishiga, Nobuaki, c/o Melco Display Tech Inc, Kukichi-gun Kumamoto 861-1198 (JP); Inoue, Kazunori, Chiyoda-ku, Tokyo 100-8310 (JP); Takeguchi, Toru, Chiyoda-ku, Tokyo 100-8310 (JP); Fuchigami, Hiroyuki, Chiyoda-ku, Tokyo 100-8310 (JP)
(74) Representative: Hofer, Dorothea

(57) **Abstract**

An organic electroluminescence type display apparatus of top emission type, in which a thin film transistor (TFT), a flattening film (15) made of organic resin and an organic EL element, in which at least an anode (16), an electroluminescence layer (18) and a cathode (19) are laminated on the flattening film in this order, are formed in each picture element in a display region on a substrate (1) The anode is composed of at least two layer film including an aluminium (Al) alloy film (16a) containing as a impurity at least one of transition metals of the eighth group of 3d into Al and including a light transmitting conductive oxide film (16b) laminated on the Al alloy film.

## Description

### BACKGROUND OF THE INVENTION

### 1. Field of the Invention

The present invention relates to an electro-optic display apparatus. More particularly, the present invention relates to an organic electroluminescence type display apparatus in which an organic electroluminescence type element, which will be referred to as an organic EL element hereinafter, is formed in a picture element region as an electro-optic element on an active matrix type substrate on which TFT is formed.

### 2. Description of the Related Art

In recent years, an organic electroluminescence type display apparatus, in which a light emitter such as an organic EL element is used as an electro-optic element, has been commonly used as one of the display panels.

The organic EL element is essentially composed in such a method that an electroluminescence layer containing an organic EL layer is interposed between the anode and the cathode. When voltage is impressed between the anode and the cathode, positive holes are injected from the anode side and electrons are injected from the cathode side, so that light can be emitted from the organic EL layer. Concerning this technique, for example, refer to Japanese Patent No. 2597377 (Fig. 1).

The organic electroluminescence type display apparatus, which is a display apparatus using the above organic EL element, is composed as follows. On TFT active matrix substrate on which a thin film transistor (referred to as TFT hereinafter) is arranged as a switching element, the organic EL element, in which the anode, the electroluminescence layer and the cathode are laminated in this order, is formed in each picture element in the display panel region.

The conventional organic electroluminescence type display apparatus is referred to as a lower face emission type (a bottom emission type) in which TFT and the organic EL element are formed on a glass-like transparent insulating substrate. In order to emit light, which has been generated from the organic EL layer of the organic EL elements, to the reverse side of the transparent insulating substrate on which TFT is not formed, the anode is made of conductive material having a light transmitting property such as indium oxide In₂O₃ + tin oxide SnO₂ (referred to as ITO hereinafter). In order to enhance the hole injection efficiency to the organic EL layer, it is preferable that the anode is made of conductive material, the work function value of which is high. For example, according to Japanese Patent No. 2597377, it is described that the preferable work function value is 4.0 eV or more. The work function value of ITO is approximately 4.7 eV. Therefore, ITO is preferably used for the anode.

However, in the case of the bottom emission type, the following problems may be encountered. Since light can not be transmitted through the regions on the substrate in which TFT pattern, the wiring pattern or the signal driving pattern is formed, the effective light emitting area is decreased. In order to solve these problems, they have developed an upper face emitting type (a top emission type) in which the light emitting area can be extended.

In the case of the top emission type, since the above anode is made of metallic material having a light reflecting property, when light generated on the organic EL layer is transmitted through the cathode and reflected to an upper portion of the substrate, the reflected light, which is reflected by this metallic material, can be simultaneously irradiated to an upper portion of the substrate. Therefore, it is possible to display a bright image.

In order to obtain a bright image, the luminous efficiency of which is high, in the top emission type, a high work function value and a high light reflectance are required for the anode. However, in the case where Cr (about 4.5 eV) or Mo (about 4.6 eV) is selected as metallic material having a high work function value, while considerations being given to the working property of patterning, the metallic film of Cr or Mo is low in the light reflectance. For example, according to the result of the experiment made by the present inventors, the light reflectance of Cr is 67% and the light reflectance of Mo is 60% at the wave length of 550 nm. Therefore, when Cr or Mo is applied to the anode, a big loss is caused in the above reflected light. On the other hand, for example, in the case where Al, Ag or alloy of Al or Ag is selected as metallic material, the light reflectance of which has a high value of not less than 90%, since the work function value is lower than 4.0 eV which is a preferable value, it is impossible to enhance the luminous efficiency of the organic EL element.

In order to solve the above problems, the following anode structure is disclosed, for example, in JP-A-2001-291595 (Fig. 1), JP-A-2003-77681 (Fig. 1), JP-A-2003-288993 (Fig. 1), and JP-A-2004-31324 (Fig. 5). Conductive material, the work function value of which is high, is laminated on an upper layer made of Ag, Al or alloy of Ag or A1, the light reflectance of which is high, so as to form at least the two layer structure. In this way, the high reflectance and the high hole injection efficiency are made to be compatible with each other. In this case, an example of the conductive material, the work function value of which is high, is a thin film of metallic oxide. Many metallic oxides have a light transmitting property and advantageous in that the light reflectance of the metal provided on the lower layer is not greatly deteriorated.

However, in general, in the case where the light transmitting conductive oxide film is formed as an upper layer in the upper portion of the metallic film or the alloy film composing a light reflecting film which is a lower layer, a new oxide reacting layer of the metallic atoms of the metallic film or the alloy film provided on the lower layer with oxygen contained in the upper layer is formed on an interface between the upper layer and the lower layer. This oxygen reacting layer is an electrically insulating body. Therefore, the resistance of the device is abnormally increased, which is a well known problem. As a means for solving the above problems, the following method is disclosed, for example, in JP-A-6-196736 (pages 2 to 3) and JP-A-2000-77666 (page 3). When another metallic film is provided between the metallic film such as an aluminum film or an aluminum alloy film and the conductive oxide film, an increase in the resistance value is suppressed.

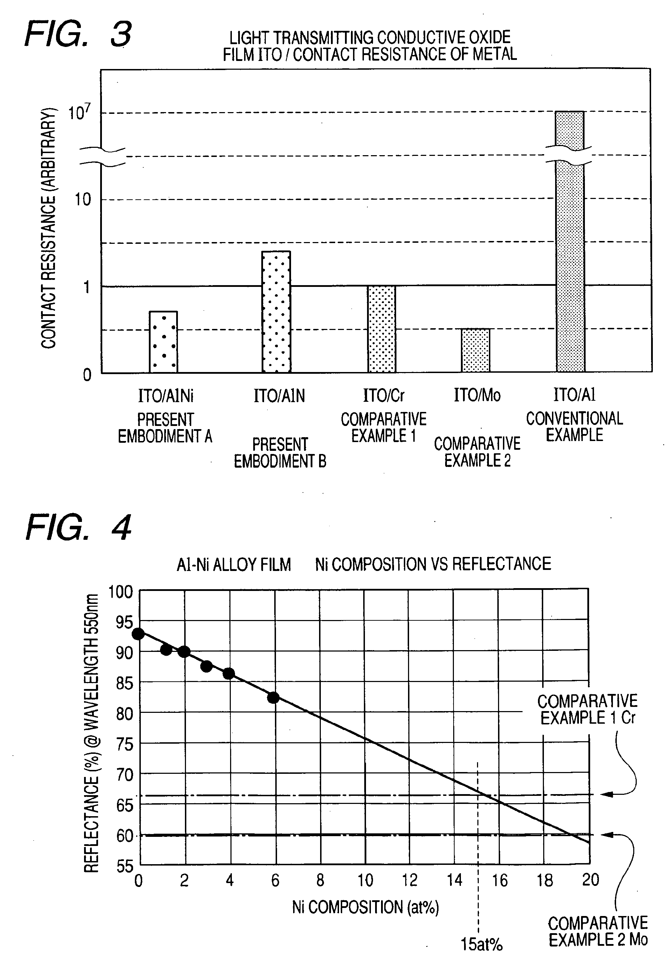

According to the experiment made by the present inventors, the following results are obtained. As can be seen in the graph shown in Fig. 3 in which the dependency of the metallic film upon the material in the contact resistance of the light transmitting conductive oxide film with the metal is shown, the electrical contact resistance value on the interface in the case where Al film or Al alloy film, which is shown as a conventional example, and ITO film, which is a light transmitting conductive oxide film, are laminated on each other is very high, that is, the electrical contact resistance value on the interface is 10⁷ times as high as that of the case of Cr assuming that the value of the case of Cr is 1, which is shown in Comparative Example 1. Accordingly, even in the case where the anode is composed in such a manner that ITO film is simply laminated on Al alloy film which is a lower layer, an oxide reacting layer, which is an electrically insulating body, is formed on the interface in the same manner. Accordingly, the hole injection efficiency to the organic EL layer is remarkably deteriorated. In order to solve this problem, in the case where such a method is employed that another metallic film is added between the conductive oxide film and Al alloy film, since it is difficult for this metal to be optimized from the viewpoint of the light reflectance, it is impossible to obtain a high light reflectance necessary for the anode. In the case where Ag film or Ag alloy film is used for the material of the high light reflectance, these materials are very active in the chemical viewpoint, and the light reflectance is deteriorated with age according to the surface oxidation in the atmosphere. Therefore, it is difficult for this method to be put into practical use. Further, in the case of Al film, surface irregularities such as hillocks tend to occur, and further a short mode failure with the opposed cathode through the organic EL layer tends to occur. Furthermore, surface defect referred to as dark spots tend to occur. In the above Patent Documents, no countermeasures for solving the above problems are disclosed. Therefore, the above methods can not be substantially applied to an actual device.

### SUMMARY OF THE INVENTION

The present invention has been accomplished to solve the above problems. The present invention obtains a bright displayed image by enhancing the luminous efficiency, in an electroluminescence type display apparatus of the top emission type, the light emitting opening area of which can be extended. The present invention provides an organic electroluminescence type display apparatus having an anode, the process working property of which is excellent, in which the surface flatness is good and the light reflectance is high and further the hole injection efficiency is high.

According to an aspect of the present invention, an organic electroluminescence type display apparatus of top emission type, in which a thin film transistor (TFT), a flattening film made of organic resin and an organic EL element, in which at least an anode, an electroluminescence layer and a cathode are laminated on the flattening film in this order, are formed in each picture element in a display region on a substrate. The anode is composed of at least two layer film including an aluminum (Al) alloy film containing as a impurity at least one of transition metals of the eighth group of 3d into Al and including a light transmitting conductive oxide film laminated on the Al alloy film.

The anode is composed of a two-layer film including Al alloy film containing impurities of at least one of the transition metals of the eighth group of 3d selected from Fe, Co and Ni and also including a light transmitting conductive oxide film laminated on the Al alloy film. Accordingly, it is possible to prevent a generation of the electrically insulating interface reacting layer on the interface between Al alloy film and the light transmitting conductive oxide film. Accordingly, the reflecting efficiency of light generated from the organic EL element is high, and the hole injection efficiency to the organic EL layer can be enhanced. Therefore, it is possible to provide an organic electroluminescence type display apparatus, the luminous efficiency of which is high, capable of displaying a bright image.

### BRIEF DESCRIPTION OF THE DRAWINGS

Fig. 1 is a sectional view of a picture element portion showing an electroluminescence type display apparatus of the present invention;
Figs. 2A to 2H are sectional process drawings for explaining a method of manufacturing an electroluminescence type display apparatus of the present invention;
Fig. 3 is a graph showing contact resistance values of the light transmitting conductive oxide film with the anode metallic film of the embodiment of the present invention and the conventional comparative example;
Fig. 4 is a graph showing dependency of the light reflectance of Al-Ni film on the Ni composition;
Fig. 5 is a graph showing dependency of the light reflectance of AlN film on the N composition; and
Fig. 6 is a graph showing a relation between the reflectance of Al film and the film thickness and also showing a relation between the transmittance and the film thickness.

### DETAILED DESCRIPTION OF THE INVENTION

Referring to the accompanying drawings, explanations will be made into a TFT active matrix substrate and an organic EL element composing the organic electroluminescence type display apparatus of the present invention. Explanations will be also made into a manufacturing method of manufacturing the TFT active matrix substrate and the organic EL element.

### EMBODIMENT 1

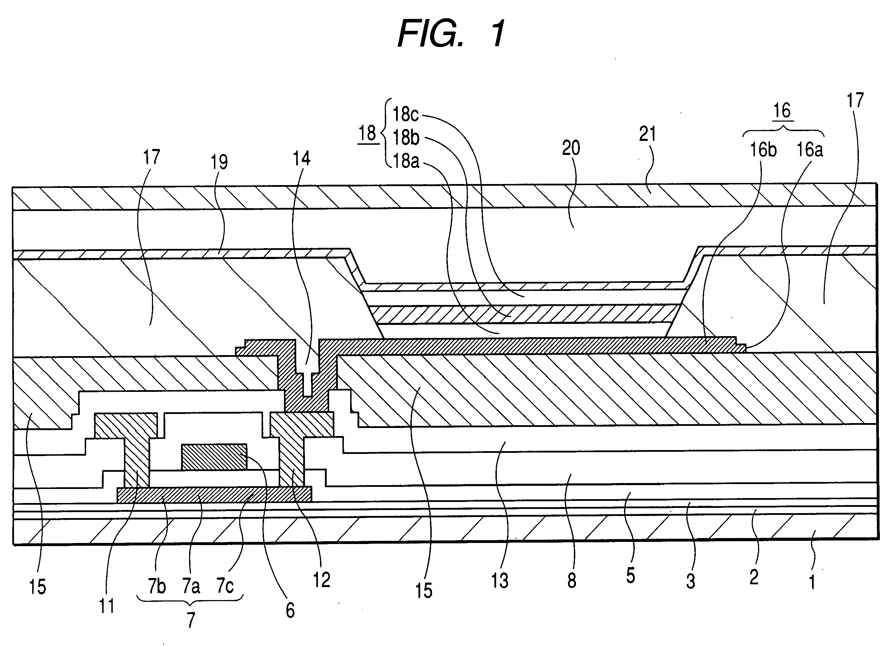

Fig. 1 is a sectional view of a picture element portion showing TFT substrate, which composes an organic electroluminescence type display apparatus of Embodiment 1 of the present invention, and also showing an organic EL element formed in an upper portion of TFT substrate. In Fig. 1, SiN film 2 is a transmitting insulating film formed on the insulating substrate 1, and the polysilicon film 7 having a channel region 7a, a source region 7b and a drain region 7c is provided on SiO₂ film 3. The gate insulating film 5 is formed in such a manner that it covers SiO₂ film 3 and the polysilicon film 7. On the gate insulating film 5, the gate electrode 6 and the first inter layer insulating film 8 made of SiO₂ are formed. The source electrode 11 and the drain electrode 12 are provided on the first inter layer insulating layer 8 and respectively connected to the source region 7b and the drain region 7c via the contact holes 9, 10. The thin film transistor is composed as described above. Further, the second inter layer insulating film 13 made of SiN or SiO₂ and the flattening film 15 made of organic resin, which flattens a surface, are provided above it.

On the flattening film 15, the anode 16 is formed in which the amorphous ITO film 16b, which is a light transmitting conductive oxide film, is laminated as the second anode on Al alloy film 16a which is the first anode. The anode 16 is connected to the drain electrode 12 on the lower layer via the contact hole 14 provided on the flattening film 15. The separation film 17 covers the anode 16 and the flattening film 15 while a portion of the separation film 17 on the anode is open. The separation film 17 is formed like a frame or like a bank in the periphery of the picture element so that the picture elements not shown, which are adjacent to each other, can be separated from each other by the separation film 17. The electroluminescence layer 18 made of organic EL material is formed on the amorphous ITO film 16b in the open region of the separation film 17. The electroluminescence layer 18 is provided right above the anode 16 and composed of three layers including the hole transporting layer 18a, the organic EL layer 18b and the electron transporting layer 18c which are laminated on each other in this order. In this connection, it is possible to adopt the well known structure in which at least one of the hole injecting layer (not shown), which is interposed between the hole transporting layer 18a and the anode 16, and the electron injecting layer (not shown), which is laminated right above the electron transporting layer 18c, is added. In this case, the electroluminescence layer 18 is composed of four or five layers. The cathode 19 and the adhesive layer 20 are formed in such a manner that they cover the separation film 17 and the electroluminescence layer 18. The cathode 19 is composed of ITO. The cathode 19 is provided so that an electric current can be made to flow to the electroluminescence layer 18 by an electrical potential difference between the cathode 19 and the anode 16. The adhesive layer 20 shuts off the electroluminescence layer 18 frommoisture and impurities. On the adhesive layer 20, the opposing substrate 21 is formed so that it can be opposed to the insulating substrate 1.

In the organic electroluminescence type display apparatus shown in Fig. 1, the signal voltage transmitted from the source electrode 11 is impressed upon the anode 16 via the drain electrode 12. By the electrical potential difference between the anode 16 and the cathode 19, an electric current flows on the electroluminescence layer 18 and the organic EL layer 18b can emit light so that displaying can be conducted. In Embodiment 10f the present invention, the anode 16 is composed of a two-layer film including Al alloy film 16a containing as a impurity at least one of the transition metals of the eighth group of 3d selected from Fe, Co and Ni into Al having a high light reflectance and also including an amorphous ITO film 16b laminated on the Al alloy film. Accordingly, on the interface between Al alloy film 16a and the amorphous ITO film 16b, no electrically insulating interface reacting layer such as an alumina layer exists. Further, when the composition of the above impurities on Al alloy film 16a is maintained in a range from not less than 0.5 at% to not more than 15 at%, it is possible to obtain an anode 16, the reflectance of which is high. Therefore, the reflectance of light generated from the organic EL element is high, and further the hole injection efficiency to the electroluminescence layer 18 can be enhanced. Accordingly, it is possible to obtain an organic electroluminescence type display apparatus, the luminous efficiency of which is high, having a bright displayed image.

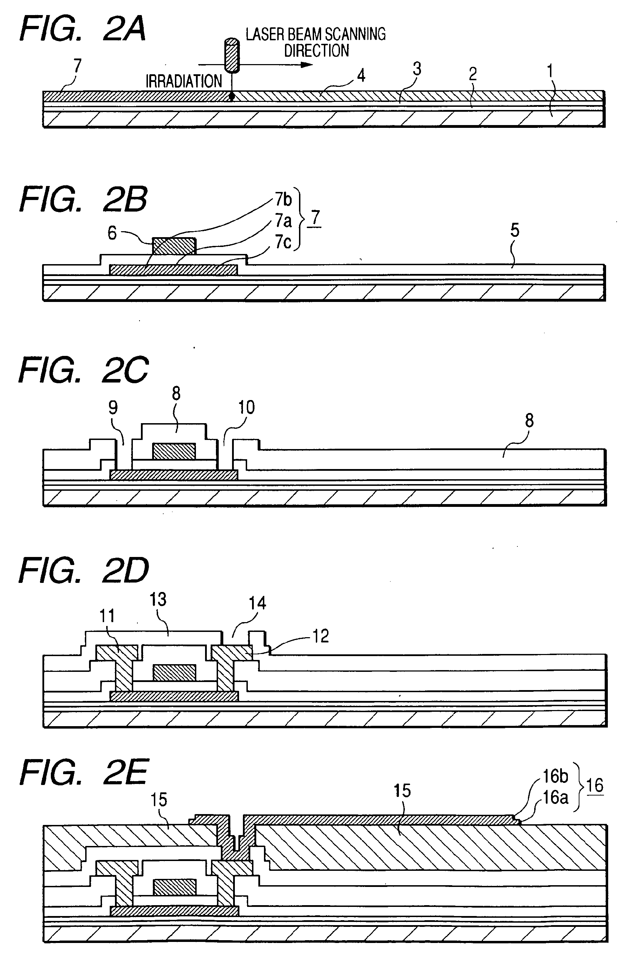

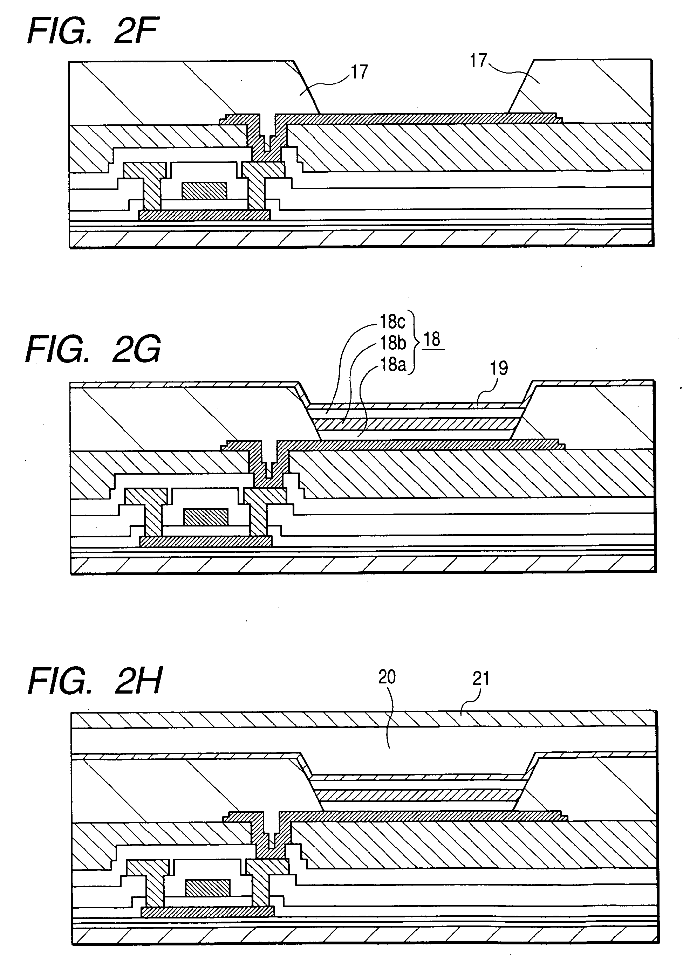

Next, referring to Figs. 2A to 2H, explanations will be made into a method of manufacturing an organic electroluminescence type display apparatus. Figs. 2A to 2H are sectional views for explaining the method of manufacturing TFT substrate composing the organic electroluminescence type display apparatus of the present invention and also explaining the method of manufacturing an organic EL element formed on TFT substrate.

Referring to Figs. 2A to 2H, explanations will be made into an embodiment of the method of manufacturing TFT substrate and the organic EL element formed on TFT substrate. In this connection, in order to simplify the explanations, only a p-type transistor is shown here.

Referring to Fig. 2A, by the method of plasma CVD-(chemical vapor deposition), SiN film 2, SiO₂ film 3 and the amorphous silicon film 4 are successively formed on the primary surface of the insulating substrate 1.

In this connection, after the amorphous silicon film 4 has been formed, the heat treatment for reducing the concentration of H (hydrogen) contained in the amorphous silicon film 4 may be executed. When the concentration of H is reduced, it is possible to prevent the occurrence of cracks which are caused by bumping of hydrogen contained in the amorphous silicon film 4 in the laser beam annealing process successively conducted.

Next, laser beams of the excimer laser (wave-length: 308 nm) are irradiated to the amorphous silicon film 4. In this case, the laser beams pass through a predetermined optical system and are converted into a beam profile on the line. Then, the laser beams are irradiated to the amorphous silicon film 4. In this laser beam annealing process, the amorphous silicon film 4 is polycrystallized, so that the polysilicon film 7 can be formed.

In this connection, in the present embodiment, a pulse type excimer laser is used as a means for polycrystallizing the amorphous silicon film 4. However, the present invention is not limited to the above specific means. For example, YAG laser or CW laser (continuous-wave laser) may be used, and further the heat annealing may be executed. In the case of executing the heat annealing, it is possible to obtain a polysilicon film 7, the grain size of which is larger, by using a catalyst such as Ni (nickel).

Referring to Fig. 2B, a resist film not shown having a predetermined opening pattern is formed on the polysilicon film 7. When etching is conducted on the polysilicon film 7 while the resist film is being used as a mask, the polysilicon film 7 is formed into a predetermined shape. After that, the resist film is removed.

Next, by the plasma CVD method, the gate insulating film 5 for covering the polysilicon film 7 is formed. Next, by the sputtering method, a metallic film for forming the gate electrode 6 is formed on the gate insulating film 5. On this metallic film, a resist film not shown having a predetermined opening pattern is formed. While the resist film is being used as a mask, the metallic film is etched and the gate electrode 6 is formed. After that, the resist film is removed.

By the ion doping method, a predetermined dose of boron is injected to the polysilicon film 7. In this case, when boron is injected to both end portions of the polysilicon film 7 while the gate electrode 6 is being used as a mask, the source region 7b and the drain region 7c are formed on the polysilicon film 7. A portion where boron is not injected becomes a channel region 7a.

Referring to Fig. 2C, the first inter layer insulating film 8 to cover the gate electrode 6 is formed on the gate insulting film 5. A resist film not shown having a predetermined opening pattern is formed on the first inter layer insulating film 8. While the resist film is being used as a mask, etching is conducted on the first inter layer insulating film 8 and the gate insulating film 5, and the contact holes 9, 10 respectively extending to the source region 7b and the drain region 7c are formed. After that, the resist film is removed.

Referring to Fig. 2D, the source electrode 11 and the drain electrode 12 respectively having a predetermined shape are formed on the first inter layer insulating film 8 so that the source electrode 11 and the drain electrode 12 can be respectively connected to the source region 7b and the drain region 7c via the contact holes 9, 10. After the completion of forming the source electrode 11 and the drain electrode 12, they are exposed to the hydrogen plasma atmosphere for 30 minutes. When this process is executed, the defect existing on the polysilicon film 7 can be eliminated by the action of H. Accordingly, it is possible to form a transistor of high performance, the reliability of which is high.

Next, by the plasma CVD method, the second inter layer insulating film 13 for covering the source electrode 11 and the drain electrode 12 is formed on the first inter layer insulating film 8. On this second inter layer insulating film 13, a resist film not shown having a predetermined opening pattern is formed. While this resist film is being used as a mask, the inter layer insulating film is etched, so that the contact hole 14 extending to the drain electrode 12 can be formed. After that, the resist film is removed.

Referring to Fig. 2E, on the second inter layer insulating film 13, the flattening film 15 having an opening portion extending to the drain electrode 12 is formed so that it can be overlapped with a portion of the contact hole 14 or the entire contact hole 14. The flattening film 15 is formed as follows. An organic film, for example, an organic film of the brand name PC335, which is made by JSR and a light transmitting acrylic photosensitive resin film, is coated by the spinning coat method so that the film thickness can be about 2 µm, and then an opening portion extending to the drain electrode 12 is formed by the photolithography method. In order to cure the flattening film 15, annealing is conducted at the temperature 220°C. When the flattening film 15 is formed, irregularities on the gate electrode 6, the source electrode 11 and the drain electrode 12 are covered with the flattening film 15, so that the array surface can be flattened.

Next, as the first anode of the anode 16, by the sputtering method using a target in which nickel (Ni) is added to aluminum (Al), Al alloy film 16a, in which nickel (Ni) is added to aluminum (Al) by 2 at% as impurities, is formed by the thickness 50 nm. Successively, as the second anode, the amorphous ITO film 16b, which is a light emitting conductive oxide film, is formed by the thickness 20 nm. After that, by the photolithography process, a resist film having a predetermined opening is formed. Then, while this resist film is being used as a mask, the amorphous ITO film 16b and Al alloy film 16a are etched in a solution containing oxalic acid and successively etched in a solution containing phosphoric acid + nitric acid + acetic acid. After that, the resist is removed.

In this case, Ni is added to Al as impurities, however, impurities are not limited to Ni. At least one of Fe and Co, which is a transition metal of the eighth group of 3d, may be added. When at least one of the transition metals of the eighth group of 3d is added to Al, it is possible to suppress the formation of the insulating oxide reaction layer on the interface with the light transmitting conductive oxide film laminated on the upper layer. Therefore, the deterioration of the hole injection efficiency can be prevented. It is preferable that the quantity of addition is not less than 0.5 at% and not more than 15 at%. In the dependency upon the material of the anode metallic film in the contact resistance value with the light transmitting conductive oxide film shown in Fig. 3, as shown by the present embodiment A, the contact resistance in the case of laminating ITO film on Al alloy film in which Ni is added to Al is greatly reduced as compared with the conventional example showing a contact resistance in the case where Al film not added with Ni and ITO film are laminated on each other. The contact resistance in the case of laminating ITO film on Al alloy film in which Ni is added to Al is approximately the same as the contact resistance in the case where Mo or Cr, which is a high melting point metal shown in Comparative Examples 1 and 2, is laminated by ITO. When Ni is added by not less than 0.5 at%, the generation of the insulating oxide reaction layer formed between Al alloy film 16a and the amorphous ITO film 16b, which is a light transmitting conductive oxide film, can be suppressed. Therefore, it is possible to obtain an excellent electrical contact characteristic. On the other hand, in the case where Ni is added by not more than 15 at%, as can be seen in Fig. 4 showing the dependency of the light reflectance of Al alloy film at the wave-length 550 nm upon the Ni composition, the light reflectance of Al alloy film can be made to be same as the light reflectance of Cr or Mo shown in Comparative Examples 1 and 2. Alternatively, the light reflectance of Al alloy film can be made to be higher than the light reflectance of Cr or Mo shown in Comparative Examples 1 and 2. Therefore, when the light emitted from the electroluminescence layer 18 is reflected, the reflected light can more greatly contribute to the display light, which is preferable.

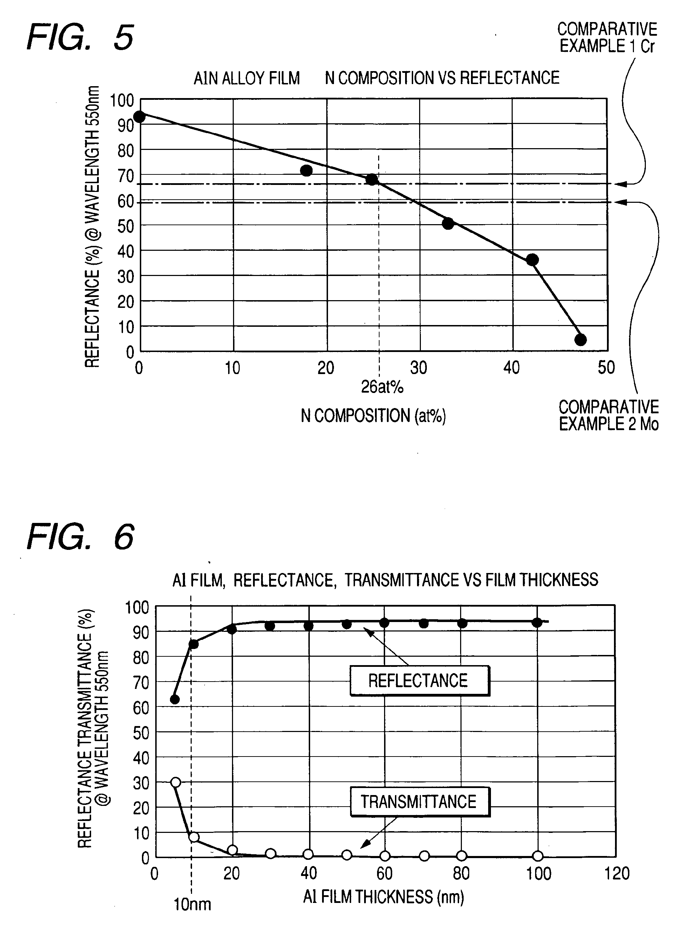

Alternatively, N may be added to Al as impurities. It is preferable that N is added by not less than 5 at% and not more than 26 at%. As shown in the present embodiment B in Fig. 3, the contact resistance in the case where ITO film is laminated on Al alloy film in which N is added to Al is a little higher than the contact resistance in the case where Mo or Cr, which is a high melting point metal, is laminated by ITO shown in Comparative Example; however, it is greatly reduced as compared with the conventional example in which N is not added. When N is added, the generation of the insulating oxide reaction layer formed between Al alloy film 16a and the amorphous ITO film 16b, which is a light transmitting conductive oxide film, can be suppressed, and an excellent electrical contact characteristic can be obtained. On the other hand, in the case where N into the Al is added by not more than 26 at%, as can be seen in Fig. 5 showing the dependency of the light reflectance of Al alloy film at the wave-length 550 nm upon the N composition, the light reflectance of Al alloy film can be made to be same as the light reflectance of Cr or Mo shown in Comparative Examples 1 and 2. Alternatively, the light reflectance of Al alloy film can be made to be higher than the light reflectance of Cr or Mo shown in Comparative Examples 1 and 2. Therefore, when the light emitted from the electroluminescence layer 18 is reflected, the reflected light can more greatly contribute to the display light.

Concerning the region in which N is added, it is preferable that N is added to a region coming into contact with the amorphous ITO film 16b, that is, an upper layer portion close to the surface of Al alloy film 16a. In this case, both the excellent conductivity of Al alloy film 16a and the excellent electrical contact characteristic with the amorphous ITO film 16b can be obtained. Therefore, the deterioration of the hole injection efficiency can be further prevented. In order to compose this structure, for example, at the time of forming Al alloy film 16a by the sputtering method, when a film is going to be formed in the Al alloy film surface portion, nitrogen gas may be added to the sputtering gas such as Ar gas. Further, in Al alloy film in which N and Ni are added to Al, the same effect can be provided.

Further, it is preferable that impurities of at least one of Cu, Si, Y and Nd are added to the above Al alloy film 16a. When the above impurities are added, the heat resistance of Al alloy film 16a can be enhanced, and the generation of irregularities on the surface such as hillocks can be prevented. Therefore, since the electrical short circuit with the cathode, which is caused by the surface irregularities, can be prevented, the generation of the defective display such as a so-called dark spot can be suppressed, and the quality of display can be enhanced.

In Embodiment 1, the film thickness of Al alloy film 16a is 50 nm. However, the film thickness of Al alloy film 16a may be in a range from not less than 10 nm to not more than 200 nm. In Fig. 6, the dependency of Al film upon the film thickness with respect to the light reflectance and the light transmission ratio of Al film at the wave-length 55O nm is shown. As can be seen in Fig. 6, in the case where the film thickness of A1 alloy film is not less than 10 nm, the light transmitting component can be sufficiently reduced, and the light reflectance of A1 alloy film can be made to be same as that of Cr and Mo shown in Comparative Examples 1 and 2. Alternatively, the light reflectance of Al alloy film can be made to be higher than that of Cr and Mo shown in Comparative Examples 1 and 2. Therefore, when the light emitted from the electroluminescence layer 18 is reflected, the reflected light can more greatly contribute to the display light, which is preferable. When the film thickness of Al alloy film is increased, the grain size is also increased, and surface irregularities become rough. Therefore, when Al alloy film is used for the anode of the organic electroluminescence display apparatus, the defective coating is caused by the electroluminescence layer 18, which causes a failure of the short mode with the cathode. Concerning the target of the surface smoothness, it is preferable that the average roughness Ra is not more than 1.0 nm. From this viewpoint, it is preferable that the film thickness of Al alloy film 16a is not more than 200 nm.

The amorphous ITO film 16b is 20 nm in film thickness. However, the film thickness is not limited to the above specific value. The film thickness may be not less than 3.5 nm. When the film thickness is not less than 3.5 nm, it is possible to forma uniform laminated film. Therefore, a failure in display caused by a defective film can be prevented.

ITO film 16b has a function of enhancing the hole injection efficiency. In addition to that, ITO film 16b has a function of acting as an optical passage element in the case where light emitted from the electroluminescence layer 18 shown in Fig. 1 is reflected on the surface of Al alloy film, 16a of the anode. Accordingly, it is preferable that the film thickness of ITO film 16b is determined so that a high luminous efficiency can be obtained while consideration is being given to the interference effect of the component of light, which is sent from the organic EL layer 18b, which is a light emitting layer, and directly emitted to the cathode 19 side with the component of light which is reflected on Al alloy film 16a of the anode 16 and emitted to the cathode 19 side. Further, in the case where the hole transporting layer 18a and others are formed on the lower layer of the organic EL layer 18b of the electroluminescence layer 18 as described later, it is preferable that the film thicknesses of these layers are determined according to the optical passage formed by the lamination structure of these films and ITO film 16b.

The laminated film is obtained as described above which is composed of the amorphous ITO film 16b, which is a light transmitting conductive oxide film of a preferable thickness, and Al alloy film 16a. After that, by the photolithography process, a resist film having a predetermined opening is formed on this laminated film. Then, while this resist film is being used as a mask, the amorphous ITO film 16b and Al alloy film 16a are etched in a solution containing oxalic acid and successively etched in a solution containing phosphoric acid + nitric acid + acetic acid. In this way, the predetermined pattern is obtained. In the etching process in which the solution containing phosphoric acid + nitric acid + acetic acid is used, the etching speed of the amorphous ITO film 16b is lower than that of Al alloy film 16a. Therefore, the cross-sectional portion of the edge portion of the anode 16 pattern is formed into a shape of the eaves. Therefore, the pattern of the amorphous ITO film 16b is larger than the pattern of Al alloy film 16a, which is a lower layer, by the size of the eaves. Accordingly, the pattern of the amorphous ITO film 16b is formed into a shape involving the pattern of Al alloy film 16a. If the separation film 17 shown in Fig. 1 is formed while the above shape of the eaves is being left as it is, a cavity is formed in the lower portion of the eaves. Accordingly, there is a possibility that the moisture and impurities such as bubbles involved in the cavity deteriorate the electroluminescence layer 18 shown in Fig. 1.

Before the resist film is removed, an etching process, in which etching is conducted in a solution containing oxalic acid, may be added. Oxalic acid etches the amorphous ITO film 16b, however, it does not etch Al alloy film 16a. Since oxalic acid has such a selectivity, when etching is conducted as described above, the eaves shape of the amorphous ITO film 16b; which is usually formed in the edge portion of the pattern of the anode 16, can be improved and formed into a substantially linear shape of a step shape as shown in Fig. 2E. Therefore, it is possible to enhance the covering property of the separation film 17 formed in the later process. Accordingly, it is possible to prevent the impurities, which tend to cause the deterioration of the electroluminescence layer 18, from being involved in the film.

In this case, the amorphous ITO film 16b is used for the light transmitting conducting oxide film, however, the light transmitting conducting oxide film is not limited to the above specific material. Indium oxide (In₂O₃), tin oxide (SnO₂), zinc oxide (ZnO) or material in which the above oxides are mixed may be used. These materials can be etched in a solution containing phosphoric acid + nitric acid + acetic acid. Therefore, these materials can be etched together with Al alloy film 16a, and the manufacturing process can be simplified. Compared with ITO film, In₂O₃ film and SnO₂ film, ZnO film is low in the interface reacting property to the Al alloy film 16a. Therefore, a quantity of the coagulation generated on the interface is small. This coagulation causes a defective display on the panel, and its generation proceeds by the continuous lighting of the panel. Therefore, when the generation of the coagulation on the interface is suppressed, it is possible to enhance the quality of display on the panel. Accordingly, the reliability can be enhanced.

Further, the material (ITZO) in which indium oxide, tin oxide and zinc oxide are mixed with each other may be used. In the case of ITZO film, in the same manner as that of ZnO film, the interface reacting property of ITZO film with respect to Al alloy film is low. Therefore, the effect of suppressing the generation of the coagulation on the interface is high. Further, in the case of ITZO film, in the same manner as that of the amorphous ITO film, ITZO film can be crystallized by heat treatment. Therefore, the chemical stability can be enhanced.

Next, referring to Fig. 2F, in order to ensure the region in which the electroluminescence layer 18 shown in Fig. 1 is formed being divided into each picture element portion, after an organic resin film made of polyimide has been coated, the separation film 17 is formed by the photolithography process. The separation film 17 is formed like a frame or like a bank in the periphery of the picture element so that the picture elements (not shown), which are adjacent to each other, can be separated from each other by the separation film 17. Concerning the organic resin film forming the separation film 17, it is preferable to use the material of polyimide which seldom absorbs water having bad influences on the characteristic and on the reliability of the organic EL layer 18b. In Embodiment 1 of the present invention, the material manufactured by Toray, the brand name of which is DL100, was coated by the film thickness of about 2 µm, and the frame-shaped separation film 17 was formed by the photolithography process.

Next, referring to Fig. 2G, the organic material, which becomes the electroluminescence layer 18 is formed in the picture element region by means of vapor deposition. In the present embodiment, the electroluminescence layer 18 is formed in such a manner that the hole transporting layer 18a, the organic EL layer 18b and the electron transporting layer 18c are laminated on each other in this order. Examples of the material of the hole transporting layer 18a include organic materials such as triallyl amine, aromatic hydrazon, aromatic substituted pyrazoline and stilbene which are well-known. For example, N, N-diphenyl-N, N-bis (3-methylphenyl)-1, 1'-diphenyl-4, 4' diamine (TPD) are formed into a film by the film thickness of 1 to 200 nm. Examples of the material of the organic EL layer 18b include dicyanomethylene pyrane derivative (emitting red light), coumalin (emitting green light), quinacridon (emitting green light), teraphenylbutadiene (emitting blue light), and distyril benzene (emitting blue light) which are well-known. One of these materials is formed into the organic EL layer 18b by the thickness of 1 to 200 nm. Examples of the material of the electron transporting layer 18c include oxaziazole derivative, triazole derivative, and coumalin derivative which are well-known. One of these materials is formed into a film by the film thickness of 0.1 to 200 nm.

In the above embodiment, the electroluminescence layer 18 is composed in such a manner that the hole transporting layer 18a, the organic EL layer 18b and the electron transporting layer 18c are successively laminated on each other. Further, in order to enhance the luminous efficiency of the electroluminescence layer 18, the hole transporting layer 18a may be composed of two layers of the hole injecting layer and hole transporting layer. Further, the electron transporting layer 18c may be composed of two layers of the electron transporting layer and the electron injecting layer.

Next, as the cathode 19, ITO film, which is a transparent conductive film, is formed by the thickness of 100 nm by the sputtering method. The cathode 19 is connected to the electroluminescence layer 18 on the lower layer in the picture element region. At the same time, the cathode 19 is connected to the cathode grounding electrode (not shown) on the lower layer via the contact hole not shown. It is preferable that the film surface of the cathode 19 is highly flat. Accordingly, it is preferable to form an amorphous ITO film, in the film structure of which no grain boundary is formed. The amorphous ITO film can be formed, for example, by means of sputtering in the gas in which H₂O gas is mixed with Ar gas. Concerning the amorphous ITO film, it is possible to use IZO film in which indium oxide and zinc oxide are mixed with each other. Alternatively, it is possible to use ITZO film in which zinc oxide is mixed with ITO film.

Finally, in order to prevent the light emitting characteristic of the electroluminescence layer 18 from being deteriorated by water and impurities, the entire picture element display region, in which the electroluminescence layer 18 is formed between the picture element display region and the opposing glass substrate 21, is covered with the adhesive layer 20. In this way, the organic electroluminescence type display apparatus of Embodiment 1 of the present invention is accomplished.

In the above embodiment, the polysilicon film 7 is used for the semiconductor film of TFT which becomes a switching element to drive the picture element. However, the semiconductor film is not limited to the polysilicon film 7. The amorphous silicon film may be used. The structure of TFT is not limited to the top gate type shown in Embodiment 1 of the present invention. For example, the bottom gate inverse staggered type may be employed. In Embodiment 1, only one TFT is shown in the drawing, however, a plurality of TFT may be provided for each picture element.

## Claims

1. An organic electroluminescence type display apparatus of top emission type,
in which a thin film transistor (TFT), a flattening film (15) made of organic resin and an organic EL element, in which at least an anode (16), an electroluminescence layer (18) and a cathode (19) are laminated on the flattening film in this order, are formed in each picture element in a display region on a substrate (1),
**characterized in that** the anode is composed of at least two layer film including an aluminum (Al) alloy film (16a) containing as a impurity at least one of transition metals of the eighth group of 3d into Al and including a light transmitting conductive oxide film laminated on the Al alloy film.

2. The organic electroluminescence type display apparatus according to claim 1,
wherein a ratio of composition of the transition metal of the eighth group of 3d contained in the Al alloy film is not less than 0.5 at% and not more than 15 at%.

3. An organic electroluminescence type display apparatus of top emission type,
in which a thin film transistor (TFT), a flattening film (15) made of organic resin and an organic EL element, in which at least an anode (16), an electroluminescence layer (18) and a cathode (19) are laminated on the flattening film in this order, are formed in each picture element in a display region on a substrate (1),
**characterized in that** the anode is composed of at least, two layer film including an aluminum (Al) alloy film (16a) containing as an impurity at least nitrogen (N) atoms into Al and including a light transmitting conductive oxide film laminated on the Al alloy film.

4. The organic electroluminescence type display apparatus according to claim 3,
wherein a ratio of composition of N atoms contained in the Al alloy film is not less than 5 at% and not more than 26 at%.

5. The organic electroluminescence type display apparatus according to one of claims 1 to 4,
wherein the Al alloy film further contains an impurity of at least one of Si, Cu, Y and Nd.

6. The organic electroluminescence type display apparatus according to one of claims 1 to 4,
wherein a thickness of the Al alloy film is not less than 10 nm and not more than 200 nm.

7. The organic electroluminescence type display apparatus according to claim 5,
wherein a thickness of the Al alloy film is not less than 10 nm and not more than 200 nm.

8. The organic electroluminescence type display apparatus according to one of claims 1 to 4,
wherein the light transmitting conductive oxide film is made of one of indium oxide (In₂O₃) tin oxide (SnO₂), zinc oxide (ZnO) or material in which the indium oxide is mixed with at least one of the zinc oxide and the tin oxide.

9. The organic electroluminescence type display apparatus according to claim 5,
wherein the light transmitting conductive oxide film is made of one of indium oxide (In₂O₃), tin oxide (SnO₂), zinc oxide (ZnO) or material in which the indium oxide is mixed with at least one of the zinc oxide and the tin oxide.

10. The organic electroluminescence type display apparatus according to claim 6,
wherein the light transmitting conductive oxide film is made of one of indium oxide (In₂O₃), tin oxide (SnO₂), zinc oxide (Zno) or material in which the indium oxide is mixed with at least one of the zinc oxide and the tin oxide.

11. The organic electroluminescence type display apparatus according to claim 7,
wherein the light transmitting conductive oxide film is made of one of indium oxide (In₂O₃), tin oxide (SnO₂), zinc oxide (ZnO) or material in which the indium oxide is mixed with at least one of the zinc oxide and the tin oxide.

12. The organic electroluminescence type display apparatus according to one of claims 1 to 4,
wherein the light transmitting conductive oxide film is made of oxide (ITZO) in which indium oxide (In₂O₃), tin oxide (SnO₂), and zinc oxide (ZnO) are mixed with each other.

13. The organic electroluminescence type display apparatus according to claim 5,
wherein the light transmitting conductive oxide film is made of oxide (ITZO) in which indium oxide (In₂O₃), tin oxide (SnO₂), and zinc oxide (ZnO) are mixed with each other.

14. The organic electroluminescence type display apparatus according to claim 6,
wherein the light transmitting conductive oxide film is made of oxide (ITZO) in which indium oxide (In₂O₃), tin oxide (SnO₂), and zinc oxide (ZnO) are mixed with each other.

15. The organic electroluminescence type display apparatus according to claim 7,
wherein the light transmitting conductive oxide film is made of oxide (ITZO) in which indium oxide (In₂O₃), tin oxide (SnO₂), and zinc oxide (ZnO) are mixed with each other.

16. The organic electroluminescence type display apparatus according to claim 8,
wherein a thickness of the light transmitting conductive oxide film is not less than 3.5 nm.

17. The-organic electroluminescence type display apparatus according to claim 12,
wherein a thickness of the light transmitting conductive oxide film is not less than 3.5 nm.

18. The organic electroluminescence type display apparatus according to one of claims 1 to 4,
wherein a cross-sectional shape of an edge portion of a pattern of the anode composed of at least the Al alloy film and the light transmitting conductive oxide film is a substantially linear shape or a step shape.
